# EUROPEAN PATENT APPLICATION

(11) **EP 4 550 661 A1**
(43) Date of publication of application: **07.05.2025**
(21) Application number: 24205550.7
(22) Date of filing: 09.10.2024
(51) Int. Cl.: H03F 1/02, H03F 3/195, H03F 3/24, H03F 1/32, H03F 3/72, H03F 3/45

(54) **RECONFIGURABLE POWER AMPLIFIER SYSTEM**

(30) Priority: 30.10.2023 US 202318497463
(71) Applicant: Avago Technologies International Sales Pte. Limited, Singapore 768923 (SG)
(72) Inventor: Kwon, Dae, Irvine, 92618 (US); Afsahi, Ali, Irvine, 92618 (US)
(74) Representative: Bosch Jehle Patentanwaltsgesellschaft mbH

(57) **Abstract**

A device to receive a first signal from a driver (105). The device comprising a first circuit (210), a second circuit (235), a third circuit (215), and a fourth circuit (225). The first circuit (210) to provide a second signal having a first level. The second circuit (235) to detect the first level of the first signal and to provide a third signal to control a third circuit (215) of the device. The third circuit (215) to provide a fourth signal, the fourth signal having a first level in response to a difference being smaller than a predetermined value, and the fourth signal having a second level in response to the difference being larger than the predetermined value. The fourth circuit (225) to provide a fifth signal, the fifth signal having a first level based at least on the second signal, and the fifth signal having a second level based at least on the second signal and the fourth signal.

## Description

The present disclosure is related to amplification of signals and amplifiers. Amplifiers can have multiple classes and each class of amplifier can have different characteristics.

According to an aspect, a system is provided, comprising:
a driver configured to provide a first signal to indicate a first amount of power and the first signal having a first level; and
a device in communication with the driver, the device comprising:
   a first circuit configured to:
      provide, in response to receipt of the first signal, a second signal having a first level based at least on the first level of the first signal;
   a second circuit configured to:
      detect, in response to receipt of the first signal, the first level of the first signal; and
      provide, in response to detection of the first level of the first signal, a third signal to control a third circuit of the device, wherein the third signal controls the third circuit by defining a difference between a first terminal and a second terminal of the third circuit of the device;
   the third circuit configured to:
      provide, in response to receipt of the first signal and the third signal, a fourth signal, the fourth signal having a first level in response to the difference being smaller than a predetermined value, and the fourth signal having a second level in response to the difference being larger than the predetermined value; and
   a fourth circuit configured to:
      provide, in response to receipt of the second signal and the fourth signal, a fifth signal, the fifth signal having a first level based at least on the first level of the second signal, and the fifth signal having a second level based at least on the first level of the second signal and the second level of the fourth signal.

Advantageously,
the fifth signal has the first level in response to the fourth signal having the first level; and
the fifth signal has the second level in response to the fourth signal having the second level.

Advantageously, the second level of the fifth signal is larger than the second level of the fourth signal, and wherein the second level of the fourth signal is larger than first level of the second signal.

Advantageously, the first level of the second signal is larger than the first level of the fourth signal, and wherein the first level of the second signal is smaller than the second level of the fourth signal.

Advantageously, the first level of the first signal has a first value in response to the first amount of power pertaining to a first mode of the device, and wherein the first level of the first signal has a second value in response to the first amount of power pertaining to a second mode of the device.

Advantageously, the first mode of the device pertains to communication corresponding to a first protocol, and wherein the second mode of the device pertains to communication corresponding to a second protocol.

Advantageously, the system further comprises:
a fifth circuit configured to:
receive, prior to the fourth circuit, the fourth signal;
adjust, in response to the fourth signal having the first level, a first amount of resistance experienced by the first circuit from a first value to a second value; and
provide, in response to adjustment in the first amount of resistance, the fourth signal to the fourth circuit;
wherein the second value of the first amount of resistance dictates the first level of the fifth signal;
wherein the second value of the first amount of resistance is larger than the first value of the first amount of resistance.

Advantageously, the fifth circuit is configured to adjust the first amount of resistance by:
modifying a second amount of resistance associated with the fourth signal from a first value to a second value; and
wherein the second value of the second amount of resistance is less than the second value of the first amount of resistance.

Advantageously, the fifth circuit is positioned between the third circuit and the fourth circuit, and wherein the fifth circuit is located in series to the third circuit and the fourth circuit.

Advantageously, the system further comprises:
a fifth circuit configured to:
receive, prior to the fourth circuit, the fourth signal;
adjust, in response to the fourth signal having the second level, a first amount of resistance experienced by the first circuit from a first value to a second value; and
provide, in response to adjustment in the first amount of resistance, the fourth signal to the fourth circuit;
wherein the second value of the first amount of resistance is smaller than the first value of the first amount of resistance;
wherein an amount of the fifth signal that is based on the first level of the second signal is reduced in response to the first amount of resistance having the second value.

Advantageously, the system further comprises:
the first circuit configured to receive a first instance of the first signal; and
the third circuit configured to receive a second instance of the first signal;
wherein the second instance of the first signal is offset from the first instance of the first signal by a predetermined amount.

According to an aspect, a device is provided in communication with a driver, the device configured to receive a first signal from the driver, and the device comprising:
a first circuit configured to:
   provide, in response to receipt of the first signal, a second signal having a first level based at least on a first level of the first signal;
a second circuit configured to:
   detect, in response to receipt of the first signal, the first level of the first signal; and
   provide, in response to detection of the first level of the first signal, a third signal to control a third circuit of the device, wherein the third signal controls the third circuit by defining a difference between a first terminal and a second terminal of the third circuit of the device;
the third circuit configured to:
   provide, in response to receipt of the first signal and the third signal, a fourth signal, the fourth signal having a first level in response to the difference being smaller than a predetermined value, and the fourth signal having a second level in response to the difference being larger than the predetermined value; and
a fourth circuit configured to:
   provide, in response to receipt of the second signal and the fourth signal, a fifth signal, the fifth signal having a first level based at least on the first level of the second signal, and the fifth signal having a second level based at least on the first level of the second signal and the second level of the fourth signal.

Advantageously:
the fifth signal has the first level in response to the fourth signal having the first level; and
the fifth signal has the second level in response to the fourth signal having the second level.

Advantageously, the second level of the fifth signal is larger than the second level of the fourth signal, and wherein the second level of the fourth signal is larger than first level of the second signal.

Advantageously, the first level of the second signal is larger than the first level of the fourth signal, and wherein the first level of the second signal is smaller than the second level of the fourth signal.

Advantageously, the device further comprises:
a fifth circuit configured to:
receive, prior to the fourth circuit, the fourth signal;
adjust, in response to the fourth signal having the first level, a first amount of resistance experienced by the first circuit from a first value to a second value; and
provide, in response to adjustment in the first amount of resistance, the fourth signal to the fourth circuit;
wherein the second value of the first amount of resistance dictates the first level of the fifth signal;
wherein the second value of the first amount of resistance is larger than the first value of the first amount of resistance.

Advantageously, the device further comprises:
a fifth circuit configured to:
   receive, prior to the fourth circuit, the fourth signal;
   adjust, in response to the fourth signal having the second level, a first amount of resistance experienced by the first circuit from a first value to a second value; and
   provide, in response to adjustment in the first amount of resistance, the fourth signal to the fourth circuit;
   wherein the second value of the first amount of resistance is smaller than the first value of the first amount of resistance;
   wherein an amount of the fifth signal that is based on the first level of the second signal is reduced in response to the first amount of resistance having the second value.

According to an aspect, a method comprises:
receiving, by a device, from a driver, a first signal to indicate a first amount of power and the first signal having a first level;
providing, by a first circuit of the device, in response to receipt of the first signal, a second signal having a first level based at least on the first level of the first signal;
detecting, by a second circuit of the device, in response to receipt of the first signal, the first level of the first signal;
providing, by the second circuit of the device, in response to detection of the first level of the first signal, a third signal to control a third circuit of the device, wherein the third signal controls the third circuit by defining a difference between a first terminal and a second terminal of the third circuit of the device;
providing, by the third circuit of the device, in response to receipt of the first signal and the third signal, a fourth signal, the fourth signal having a first level in response to the difference being smaller than a predetermined value, and the fourth signal having a second level in response to the difference being larger than the predetermined value; and
providing, by a fourth circuit of the device, in response to receipt of the second signal and the fourth signal, a fifth signal, the fifth signal having a first level based at least on the first level of the second signal, and the fifth signal having a second level based at least on the first level of the second signal and the second level of the fourth signal.

Advantageously:
the first level of the first signal has a first value in response to the first amount of power pertaining to a first mode of the device;
the first level of the first signal has a second value in response to the first amount of power pertaining to a second mode of the device;
the first mode of the device pertains to communication corresponding to a first protocol; and
the second mode of the device pertains to communication corresponding to a second protocol.

Advantageously, the method further comprises:
receiving, by a fifth circuit of the device, prior to the fourth circuit, the fourth signal;
adjusting, by the fifth circuit of the device, in response to the fourth signal having the first level, a first amount of resistance experienced by the first circuit from a first value to a second value; and
providing, by the first circuit of the device, in response to adjustment in the first amount of resistance, the fourth signal to the fourth circuit;
wherein the second value of the first amount of resistance dictates the first level of the fifth signal;
wherein the second value of the first amount of resistance is larger than the first value of the first amount of resistance.

### BRIEF DESCRIPTION OF THE DRAWINGS

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.
FIG. 1 is a block diagram of a system for use in configuring an amplifier, according to some embodiments.
FIG. 2 is a schematic block diagram of one or more components of the system illustrated in FIG. 1, according to some embodiments.
FIG. 3 is a schematic block diagram of one or more components of the system illustrated in FIG. 1, according to some embodiments.
FIG. 4 is a schematic block diagram of one or more components of the system illustrated in FIG. 1, according to some embodiments.
FIG. 5 is a schematic block diagram of one or more components of the system illustrated in FIG. 1, according to some embodiments.
FIG. 6 is a schematic block diagram of one or more components of the system illustrated in FIG. 1, according to some embodiments.
FIG. 7 is a schematic block diagram illustrating a bias between one or more terminals of an amplifier, according to some embodiments.
FIG. 8 is a schematic block diagram of one or more components of the system illustrated in FIG. 1, according to some embodiments.
FIG. 9 is a schematic block diagram of one or more components of the system illustrated in FIG. 1, according to some embodiments.
FIG. 10 is a schematic block diagram of one or more components of the system illustrated in FIG. 1, according to some embodiments.
FIG. 11 is a schematic block diagram of one or more components of the system illustrated in FIG. 1, according to some embodiments.
FIG. 12 is a block diagram of a process of configuring an amplifier, according to some embodiments.

### DETAILED DESCRIPTION

Some embodiments are related to systems and methods for configuring a power amplifier system to control efficiency of the power amplifier system. Efficiency of the power amplifier system may include a difference between an amount of power provided to an amplifier and an amount of power provided by the amplifier. As another example, efficiency of the power amplifier system may include a difference between a saturation amount and an amount of power provided by an amplifier. A saturation amount may refer to and/or include an amount of power that, once exceeded, does not result in any additional amplification. A saturation amount for an amplifier may impact and/or influence an efficiency of the amplifier. For example, an efficiency of an amplifier may continue to increase as a voltage level of an input signal approaches (but does not exceed) the saturation amount. To continue this example, the efficiency of the amplifier may decrease as the voltage level of the input signals exceeds the saturation amount.

An amplifier is generally electrically coupled to a power supply and the power supply provides power to the amplifier. The power supply generally provides the power to the amplifier at a given voltage or current level (e.g., 0.7 volts, 1 volt, 5 volts, 10 volts, 12 volts, etc.). The given voltage or current may be Direct Current (DC), Alternating Current (AC), and/or other varying combinations. The voltage level or current level provided to the amplifier can impact the efficiency of the amplifier. For example, the level of voltage provided to power supply terminals of the amplifier may establish an output range for the amplifier (e.g., the output of the amplifier may be unable to exceed the amount of power (e.g., voltage level) provided to the amplifier from the power supply). Additionally, characteristics of input signals may also impact the efficiency of the amplifier.

Devices may include amplifiers for one or more given functions and/or implementations. For example, an antenna may include a first amplifier and a second amplifier. To continue this example, the first amplifier may be implemented in a Wireless Local-Area-Network (WLAN) system and the second amplifier may be implemented in a Bluetooth system. Saturation amounts for WLAN signals and Bluetooth signals may be different. WLAN signals may be associated with a larger decibel level (relative to Bluetooth signals). For example, WLAN signals may include signals that have decibel amounts that are 5dB (e.g., 5 decibels) larger than Bluetooth signals. To continue this example, the antenna may designate and/or include space for both the first amplifier and the second amplifier. The allocation of space for the first amplifier and the second amplifier may increase an overall size of the antenna. The implementation of the antenna including the first amplifier and the second amplifier may result in a trade-off between efficiency and an overall size of the antenna. For example, the overall size of the antenna may be decreased with the removal of one of the amplifiers. The efficiency of the antenna may be impacted as a single amplifier may then be utilized in both of the use cases above (e.g., WLAN signals and Bluetooth).

Some technical solutions and advantages of some embodiments are related to a system including a device that can control (e.g., turn on and/or turn off) an amplifier to adjust an efficiency of the system. For example, the device may determine, based on a voltage level of an input signal, to control an amplifier to control a voltage level of an output signal. The device may control the efficiency of the system by turning the amplifier off (when a saturation amount for the output signal is a first level) and by turning the amplifier on (when the saturation amount for the output signal is a second level). For example, the device may receive a first signal and the device may detect that the first signal pertains to a WLAN signal. To continue this example, the device may turn on a first amplifier to increase a voltage level of an output signal.

In some embodiments, the device may include at least one circuit. For example, the device can include a first circuit, a second circuit, and a third circuit. In some embodiments, the device may be in communication with a driver (e.g., a remote and/or external amplifier). The communication between the device and the driver can be direct (e.g., the device is directly connected to the driver and the device directly communicates with the driver) and/or indirect (e.g., a component receives signals from the driver and the component provides the signals to the device) in some embodiments. The communication between the device and the driver can include the device and driver being electrically coupled with one another.

A system may refer to and/or include at least one of Application-Specific Integrated Circuits (ASIC), capacitive load components, display drivers, touch screens, keyboard sensors, mobile devices, and/or among other possible touch controllers. A device may refer to and/or include at least one an integrated circuit, a general purpose processor, a multicore processor, a software programmable device, a programmable logic controller, and/or among other possible circuitry and/or hardware, in some embodiments. Similarly, the functionality of the device may be stored, in memory, as software and/or as instructions and when the information (e.g., the software and/or instructions) stored in memory are executed, by a processor, results in the processor performing the functionality of the device (e.g., the processor can monitor output signals and control an amount of voltage provided to the driver) and/or performing the functionality of a component of the device (e.g., the first circuit, the second circuit, and/or the third circuit).

A circuit may refer to and/or include at least one of an operational amplifier (Opamp), a comparator circuit, filters, a digital signal processing engine, a pattern generator (e.g., a device that sends control signals to components of the device and/or the system), Flip Flops, logic gates, latches, state storage, an integrated circuit, a software programmable device, a programmable logic controller, and/or among other possible circuitry and/or hardware, in some embodiments.

A driver may refer to and/or include at least one of a driver circuit, an integrated circuit, an Opamp, a regulator, a software programmable device, a programmable logic controller, and/or among other possible circuitry and/or hardware, in some embodiments. A level may refer to and/or include at least one of a voltage level of a signal, an amount of voltage of a signal, an amount of power of a signal, an amount of current of a signal, and/or various combinations, in some embodiments. An amount of power may refer to and/or include at least one a voltage level, a current level, and/or various combinations.

A difference may refer to and/or include an indication of which signal (e.g., a first signal or a second signal) is larger and/or smaller from each other, a binary value (e.g., a zero or a one) to indicate whether a first signal is higher and/or lower than a second signal, and/or among various combinations, in some embodiments. A difference may also refer to a mathematical difference between two or more signals (e.g., a larger signal minus a smaller signal), a mathematical difference between two or more values and/or levels, and/or various combinations, in some embodiments. An offset may refer to and/or include at least one of a phase shift of a signal, a time shift of a signal, a delay of a signal, a modification of a time constant, and/or various combinations, in some embodiments.

A component may refer to and/or include at least one of a voltage source (e.g., batteries, current through resistors, etc.), circuity hardware (e.g., transistors, resistors, capacitors, inductors, diodes, etc.), and/or among various combinations, in some embodiments. An amount of resistance experienced by a circuit may refer to and/or include at least one of a load applied to a signal, an amount of electrical resistance, an amount of impedance, an amount of inductance, an amount of capacitance, and/or various combinations, in some embodiments.

A circuit positioned between a second circuit and third circuit may refer to and/or include at least one of the circuit being disposed between the second circuit and the third circuit, the circuit being located between the second circuit and the third circuit, the circuit being connected to the second circuit and the circuit connecting the second circuit with the third circuit, and/or various combinations, in some embodiments.

Some embodiments relate to a system. The system can include a driver and a device. The driver can provide a first signal to indicate a first amount of power and the first signal can have a first level. The device can be in communication with the driver. The device can include a first circuit. The first circuit can provide, in response to receipt of the first signal, a second signal having a first level based at least on the first level of the first signal. The device can also include a second circuit. The second circuit can detect, in response to receipt of the first signal, the first level of the first signal. The second circuit can also provide, in response to detection of the first level of the first signal, a third signal to control a third circuit of the device, the third signal can control the third circuit by defining a difference between a first terminal and a second terminal of the third circuit of the device. The third circuit can provide, in response to receipt of the first signal and the third signal, a fourth signal, the fourth signal can a first level in response to the difference being smaller than a predetermined value, and the fourth signal can have a second level in response to the difference being larger than the predetermined value. The device can also include a fourth circuit. The fourth circuit can provide, in response to receipt of the second signal and the fourth signal, a fifth signal, the fifth signal can have a first level based at least on the first level of the second signal, and the fifth signal can have a second level based at least on the first level of the second signal and the second level of the fourth signal.

In some embodiments, the fifth signal can have the first level in response to the fourth signal having the first level, and the fifth signal can have the second level in response to the fourth signal having the second level.

In some embodiments, the second level of the fifth signal can be larger than the second level of the fourth signal, and the second level of the fourth signal can be larger than first level of the second signal.

In some embodiments, the first level of the second signal can be larger than the first level of the fourth signal, and the first level of the second signal can be smaller than the second level of the fourth signal.

In some embodiments, the first level of the first signal can have a first value in response to the first amount of power pertaining to a first mode of the device, and the first level of the first signal can have a second value in response to the first amount of power pertaining to a second mode of the device.

In some embodiments, the first mode of the device can pertain to communication corresponding to a first protocol, and the second mode of the device can pertain to communication corresponding to a second protocol.

In some embodiments, the device can include a fifth circuit. The fifth circuit can receive, prior to the fourth circuit, the fourth signal. The fifth circuit can also adjust, in response to the fourth signal having the first level, a first amount of resistance experienced by the first circuit from a first value to a second value. The fifth circuit can also provide, in response to adjustment in the first amount of resistance, the fourth signal to the fourth circuit. The second value of the first amount of resistance can dictate the first level of the fifth signal. The second value of the first amount of resistance can be larger than the first value of the first amount of resistance.

In some embodiments, the fifth circuit can adjust the first amount of resistance by modifying a second amount of resistance associated with the fourth signal from a first value to a second value. The second value of the second amount of resistance can be less than second value of the first amount of resistance.

In some embodiments, the fifth circuit can be positioned between the third circuit and the fourth circuit, and the fifth circuit can be located in series to the third circuit and the fourth circuit.

In some embodiments, the device can include a fifth circuit. The fifth circuit can receive, prior to the fourth circuit, the fourth signal. The fifth circuit can also adjust, in response to the fourth signal having the second level, a first amount of resistance experienced by the first circuit from a first value to a second value. The fifth circuit can also provide, in response to adjustment in the first amount of resistance, the fourth signal to the fourth circuit. The second value of the first amount of resistance can be smaller than the first value of the first amount of resistance. An amount of the fifth signal that is based on the first level of the second signal can be reduced in response to the first amount of resistance having the second value.

In some embodiments, the first circuit can receive a first instance of the first signal. The third circuit can receive a second instance of the first signal. The second instance of the first signal can be offset from the first instance of the first signal by a predetermined amount.

Some embodiments relate to a device. The device can receive a first signal from a driver. The device can include a first circuit. The first circuit can provide, in response to receipt of the first signal, a second signal having a first level based at least on a first level of the first signal. The device can also include a second circuit. The second circuit can detect, in response to receipt of the first signal, the first level of the first signal. The second circuit can also provide, in response to detection of the first level of the first signal, a third signal to control a third circuit of the device, the third signal can control the third circuit by defining a difference between a first terminal and a second terminal of the third circuit of the device. The third circuit can provide, in response to receipt of the first signal and the third signal, a fourth signal, the fourth signal can have a first level in response to the difference being smaller than a predetermined value, and the fourth signal can have a second level in response to the difference being larger than the predetermined value. The device can also include a fourth circuit. The fourth circuit can provide, in response to receipt of the second signal and the fourth signal, a fifth signal, the fifth signal can have a first level based at least on the first level of the second signal, and the fifth signal can have a second level based at least on the first level of the second signal and the second level of the fourth signal.

In some embodiments, the fifth signal can have the first level in response to the fourth signal having the first level, and the fifth signal can have the second level in response to the fourth signal having the second level.

In some embodiments, the second level of the fifth signal can be larger than the second level of the fourth signal, and the second level of the fourth signal can be larger than first level of the second signal.

In some embodiments, the first level of the second signal can be larger than the first level of the fourth signal, and the first level of the second signal can be smaller than the second level of the fourth signal.

In some embodiments, the device can include a fifth circuit. The fifth circuit can receive, prior to the fourth circuit, the fourth signal. The fifth circuit can also adjust, in response to the fourth signal having the first level, a first amount of resistance experienced by the first circuit from a first value to a second value. The fifth circuit can also provide, in response to adjustment in the first amount of resistance, the fourth signal to the fourth circuit. The second value of the first amount of resistance can dictate the first level of the fifth signal. The second value of the first amount of resistance can be larger than the first value of the first amount of resistance.

In some embodiments, the device can include a fifth circuit. The fifth circuit can receive, prior to the fourth circuit, the fourth signal. The fifth circuit can also adjust, in response to the fourth signal having the second level, a first amount of resistance experienced by the first circuit from a first value to a second value. The fifth circuit can also provide, in response to adjustment in the first amount of resistance, the fourth signal to the fourth circuit. The second value of the first amount of resistance can be smaller than the first value of the first amount of resistance. An amount of the fifth signal that is based on the first level of the second signal can be reduced in response to the first amount of resistance having the second value.

Some embodiments relate to a method. The method can include receiving, by a device, from a driver, a first signal to indicate a first amount of power and the first signal having a first level. The method can also include providing, by a first circuit of the device, in response to receipt of the first signal, a second signal having a first level based at least on the first level of the first signal. The method can also include detecting, by a second circuit of the device, in response to receipt of the first signal, the first level of the first signal. The method can also include providing, by the second circuit of the device, in response to detection of the first level of the first signal, a third signal to control a third circuit of the device, the third signal can control the third circuit by defining a difference between a first terminal and a second terminal of the third circuit of the device. The method can also include providing, by the third circuit of the device, in response to receipt of the first signal and the third signal, a fourth signal, the fourth signal can have a first level in response to the difference being smaller than a predetermined value, and the fourth signal can have a second level in response to the difference being larger than the predetermined value. The method can also include providing, by a fourth circuit of the device, in response to receipt of the second signal and the fourth signal, a fifth signal, the fifth signal can have a first level based at least on the first level of the second signal, and the fifth signal can have a second level based at least on the first level of the second signal and the second level of the fourth signal.

In some embodiments, the first level of the first signal can have a first value in response to the first amount of power pertaining to a first mode of the device. The first level of the first signal can have a second value in response to the first amount of power pertaining to a second mode of the device. The first mode of the device can pertain to communication corresponding to a first protocol, and the second mode of the device can pertain to communication corresponding to a second protocol.

In some embodiments, the method can also include receiving, by a fifth circuit of the device, prior to the fourth circuit, the fourth signal. The method can also include adjusting, by the fifth circuit of the device, in response to the fourth signal having the first level, a first amount of resistance experienced by the first circuit from a first value to a second value. The method can also include providing, by the first circuit of the device, in response to adjustment in the first amount of resistance, the fourth signal to the fourth circuit. The second value of the first amount of resistance can dictate the first level of the fifth signal. The second value of the first amount of resistance can be larger than the first value of the first amount of resistance.

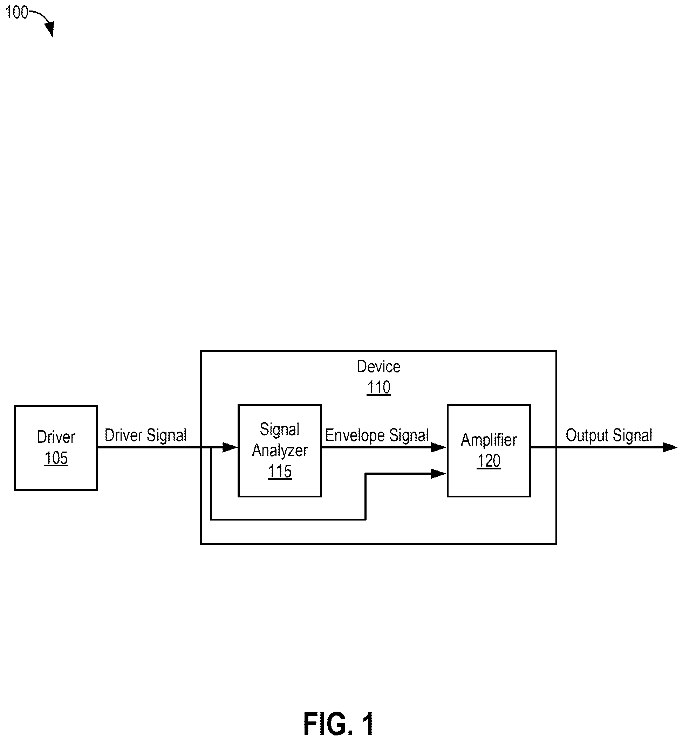

FIG. 1 depicts a block diagram of a system 100, according to some embodiments. The system 100 may refer to and/or include at least one of the systems described herein. For example, the system 100 may include the power amplifier system described herein. In some embodiments, various systems, devices, and/or components of the system 100 may be added, removed, integrated, separated, rearranged, relocated, and/or replaced. For example, a first component of the system 100 may be relocated from a first device to a second device. As another example, a device that includes one amplifier may be modified to include two amplifiers.

In some embodiments, the system 100 may be implemented as and/or housed within a communication device. For example, the system 100 may be included in an antenna. As another example, the system 100 may be located in a transceiver. In some embodiments, the system 100 and/or one or more components thereof may be included in and/or implemented as one or more components of a communication device (e.g., an antenna, a transmitter, a transceiver, a receiver, a Radio Frequency (RF) device, etc.). For example, a first component of the system 100 may include a power amplifier driver and the first component may drive an antenna.

The system 100 may include at least one driver 105 and at least one device 110, in some embodiments. In some embodiments, the driver 105 may include at least one of the drivers described herein. In some embodiments, the device 110 may include at least one of the devices described herein. In some embodiments, the device 110 may provide some of the technical solutions described herein. For example, the device 110 may control an amplifier to control an efficiency of the system 100 and/or a component thereof.

The driver 105 may be in communication with the device 110. For example, the driver 105 may be coupled with the device 110. In some embodiments, the driver 105 may be directly coupled with the device 110 (e.g., at least a portion of the driver 105 is in contact with at least a portion of the device 110). In some embodiments, the driver 105 may be indirectly coupled with the device 110. For example, the driver 105 may be directly coupled with a component and the component may also be directly coupled with the device 110. In some embodiments, the driver 105 may be electrically coupled with the device 110.

In some embodiments, the driver 105 may provide one or more signals. For example, the driver 105 may provide a first signal and a second signal. In some embodiments, the driver 105 may provide signals via wired communication. For example, the driver 105 may be electrically coupled, via a wire and/or cable, with a component. To continue this example, the driver 105 may provide, via the wire, one or more signals to the component. In some embodiments, the driver 105 may provide signals via wireless communication. For example, the driver 105 may include a transceiver and the driver 105 may provide, via the transceiver, one or more wireless signals.

In some embodiments, the driver 105 may include and/or be implemented as an Operational Amplifier (Opamp). For example, the driver 105 may receive a first signal and the driver 105 may provide a second signal that is an amplification of the first signal. In some embodiments, the driver 105 may provide a signal to indicate an amount of power. For example, the driver 105 may provide a signal having a voltage level of 5V and the voltage level of 5V may indicate an amount of power. As another example, the driver 105 may provide an amplified signal and the amplified signal (based on a gain factor of the driver 105) may indicate an amount of power.

In some embodiments, the driver 105 may provide one or more signals to the device 110. For example, the driver 105 may provide a first signal and a second signal to the device 110. The signals provided by the driver 105, to the device 110, are shown as Driver Signal in FIG. 1. In some embodiments, the driver 105 may provide one or more Driver Signals. The Driver Signals may include one or more levels. For example, the Driver Signals may include a first level and a second level. In some embodiments, the levels of the Driver Signals may indicate an amount of power. In some embodiments, the levels of the Driver Signals may have one or more values. For example, a first level of a Driver Signal may include a first value and/or a second value. As another example, a first Driver Signal may include a first level and a second Driver Signal may include a second level. To continue this example, the first level and the second level may be similar to one another (e.g., the same level) and/or different from one another (e.g., the first level is larger than and/or smaller than the second level).

In some embodiments, the levels and/or values of the Driver Signals may pertain to one or more modes of the system 100 and/or the device 110. For example, the driver 105 may provide a first Driver Signal, in response to a selection (via an input device) of a first mode. In some embodiments, the one or more modes may refer to and/or include one or more protocols. For example, a first mode may pertain to communications via Bluetooth (e.g., a protocol). As another example, a second mode may pertain to communications via WLAN (e.g., a protocol).

In some embodiments, a first value of a first Driver Signal may indicate a first mode and a second value of the first Driver Signal may indicate a second mode. For example, the first mode may pertain to communications via Bluetooth. To continue this example, a Driver Signal may have a first value (e.g., an amount of power) to indicate the first mode. As another example, the Driver Signal may have a second value to indicate a second mode.

The device 110 may receive one or more signals. For example, the device 110 may receive a first signal and a second signal. In some embodiments, the device 110 may receive the Driver Signals described herein. In some embodiments, the device 110 may control and/or implement communication via the one or more protocols described herein.

The device 110 may include a signal analyzer 115 and one or more amplifiers 120, in some embodiments. In some embodiments, the device 110 may include a first amplifier 120 and a second amplifier 120. In some embodiments, the amplifiers 120 may refer to and/or be implemented as a Doherty amplifier. In some embodiments, the signal analyzer 115 may receive one or more signals. In some embodiments, the signal analyzer 115 may be in communication with the driver 105. For example, the signal analyzer 115 may receive the Driver Signals. In some embodiments, the signal analyzer 115 may be in communication with the amplifier 120. For example, the signal analyzer 115 may be directly coupled with the amplifier 120.

In some embodiments, the signal analyzer 115 may detect one or more levels of signals. For example, the signal analyzer 115 may detect one or more levels of the Driver Signals. In some embodiments, the signal analyzer 115 may determine, in response to detecting the levels of the Driver Signals, one or more modes. For example, the signal analyzer 115 may determine that a first Driver Signal pertains to a first mode in response to the first Driver Signal having a first level that indicates the first mode.

In some embodiments, the signal analyzer 115 may provide one or more signals. For example, the signal analyzer 115 may provide a first signal. In some embodiments, the signal analyzer 115 may provide signals in response to the signal analyzer 115 receiving the Driver Signal. For example, the signal analyzer 115 may provide a first signal in response to the signal analyzer 115 receiving a first Driver Signal. In some embodiments, the signal analyzer 115 may provide one or more signals to the amplifier 120. The signals provided by the signal analyzer 115, to the amplifiers 120, are shown as Envelope Signal in FIG. 1. The Envelope Signals may refer to and/or include bias signals. For example, a first Envelope Signal may establish and/or define a bias between terminals of a first amplifier 120.

In some embodiments, the amplifiers 120 may receive one or more signals. For example, the amplifiers 120 may receive input signals. In some embodiments, the amplifiers 120 may receive signals from the driver 105. For example, the amplifiers 120 may receive the Driver Signals. In some embodiments, the amplifiers 120 may receive signals from the signal analyzer 115. For example, the amplifiers 120 may receive the Envelope Signals. In some embodiments, the amplifiers 120 may provide one or more signals. For example, the amplifiers 120 may provide amplification signals. In some embodiments, the amplifiers 120 may provide signals that are an amplification of the Driver Signals. For example, the amplifiers 120 may receive a first Driver Signal that has a voltage level of 3V. To continue this example, the amplifiers 120 may provide a signal having a voltage level of 4V (e.g., an amplified signal). The signals provided by the amplifiers 120 are shown at Output Signal in FIG. 1.

In some embodiments, the Envelope Signals may dictate and/or control the Output Signals provided by the amplifiers 120. For example, the Envelope Signals may define a difference between terminals of the amplifiers 120. To continue this example, the difference between the terminals may turn the amplifiers 120 on and/or off. Stated otherwise, the difference between the terminals of the amplifiers 120 may determine and/or dictate if the amplifiers 120 provide amplification signals. In some embodiments, the amplifiers 120 may have a predetermined threshold (e.g., a difference between terminals). For example, the predetermined threshold may be 1V. To continue this example, the amplifiers 120 may provide amplified signals (e.g., turned on) when the difference between the terminals is greater than 1V. As another example, the amplifiers 120 may provide unamplified signals (e.g., turned off) when the difference between the terminals is less than 1V.

In some embodiments, an unamplified signal may refer to signals having a voltage level that differs from a gain factor of an amplifier. For example, a first amplifier 120 may have a gain factor of 3 (e.g., the first amplifier 120 provides an amplification signal that is threes greater than a received signal). To continue this example, the first amplifier 120 may receive a first signal having a voltage level of 1V. The first amplifier 120 may provide a signal having a voltage level of 1.1V (e.g., an unamplified signal). In the example described above, the signal provided by the first amplifier 120 may be an unamplified signal as the voltage level of the signal differs from the gain factor for the first amplifier 120. In some embodiments, the amplifier 120 may provide unamplified signals when the amplifier 120 is turned off.

In some embodiments, the amplifiers 120 may provide a signal having a voltage level of 0V (e.g., turned off) when the difference between the terminals is less than 1V. In some embodiments, the amplifiers 120 may provide a signal having a level less than a level of the received signal. For example, the amplifiers 120 may receive a signal having a voltage level of 2V. To continue this example, the amplifiers 120 may provide a signal having a voltage level of 1V. In some embodiments, the amplifier 120 providing signals that have a voltage level that is less than a received signal may refer to the amplifier 120 having been turned off.

In some embodiments, the amplifiers 120 may receive the Driver Signals. The amplifiers 120 may provide (based on their gain factors) amplified signals that are based on the Driver Signals. For example, the amplifiers 120 may provide a signal that is an amplification of the Driver Signals. In some embodiments, the Envelope Signals may cause the amplifiers 120 to provide unamplified signals in response to the amplifiers 120 receiving the Driver Signals.

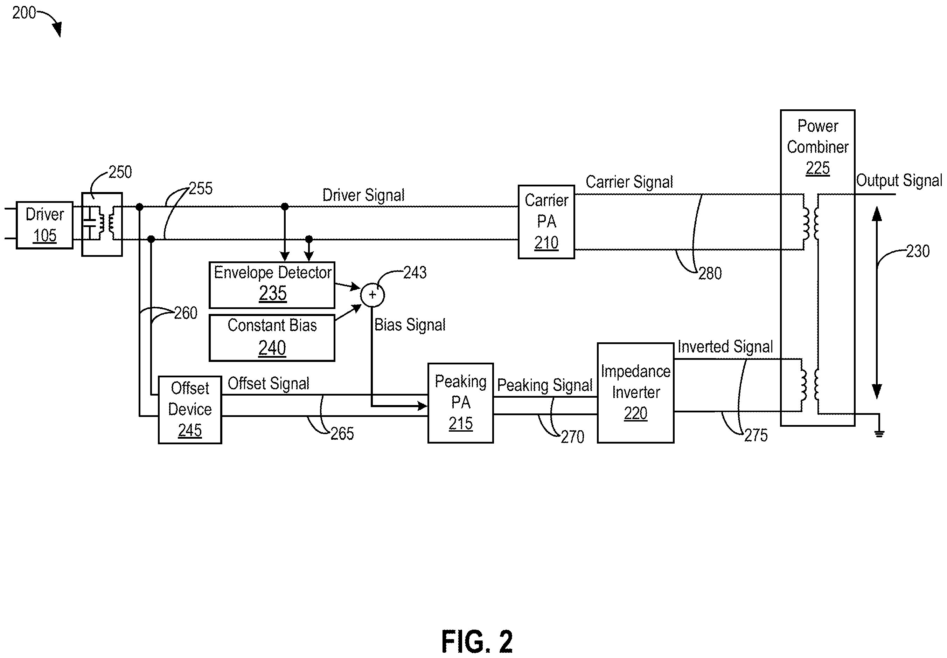

FIG. 2 depicts a schematic block diagram 200, according to some embodiments. In some embodiments, the schematic block diagram 200 may include one or more systems, devices, and/or components of the system 100. For example, the schematic block diagram 200 may include the amplifiers 120. In some embodiments, the system 100 may include and/or be implemented as the schematic block diagram 200. In some embodiments, at least one device and/or component of the schematic block diagram 200 may be included in and/or implemented within the system 100. In some embodiments, systems, devices, and/or components of the schematic block diagram 200 may be added, removed, integrated, separated, rearranged, relocated, and/or replaced. For example, a device that does not include a transformer may be modified to include a transformer. As another example, a component that is shown to be included in a first device may also be included in a second device (even if not shown in FIG. 2).

The schematic block diagram 200 may include the driver 105, at least one carrier Power Amplifier (PA) 210, at least one Peaking PA 215, at least one impedance invertor 220, at least one power combiner 225, at least one resistive element 230, at least one envelope detector 235, at least one constant bias 240, at least one summator 243, at least one offset device 245, and at least one transformer 250, in some embodiments. The components and/or devices of the schematic block diagram 200 may be in communication with one another. For example, the driver 105 may be in communication with the carrier PA 210. In some embodiments, the resistive element 230 may include and/or provide at least one of a resistance, an impedance, a capacitance, and/or an inductance.

In some embodiments, the device 110 may include and/or be implemented as the carrier PA 210 and the peaking PA 215. For example, the amplifiers 120 may include the carrier PA 210 and the peaking PA 215. As another example, the carrier PA 210 may be a first amplifier 120 and the peaking PA 215 may be a second amplifier 120. The carrier PA 210 may be located in parallel and/or series relative to the peaking PA 215. For example, the carrier PA 210 may be coupled with a first node of the schematic block diagram 200 and the peaking PA 215 may be coupled, via the carrier PA 210, with the first node. To continue this example, the carrier PA 210 and the peaking PA 215 may be considered in series (e.g., a signal provided to the first node would flow to the carrier PA 210 prior to flowing to the peaking PA 215). As another example, the carrier PA 210 and the peaking PA 215 may both be independently coupled with the first node (e.g., the carrier PA 210 is directly coupled with the first node and the peaking PA 215 is directly coupled with the first node). To continue this example, the carrier PA 210 and the peaking PA 215 may be considered in parallel (e.g., a signal provided to the first node may flow to at least one of the carrier PA 210 and/or the peaking PA 215). FIG. 2 depicts an example of the carrier PA 210 and the peaking PA 215 being located in parallel to one another.

In some embodiments, the driver 105 may be electrically coupled with the transformer 250. For example, the driver 105 may provide one or more signals to the transformer 250. In some embodiments, the driver 105 may provide the Driver Signals to the transformer 250. In some embodiments, the transformer 250 may modify, adjust, and/or change the Driver Signals. For example, the transformers 250 may be implemented as a step-up transformer (e.g., the transformers 250 increase the level of the Driver Signals). In some embodiments, the transformers may increase the voltage level of the Driver Signals.

The transformers 250 may be in communication with the carrier PA 210 and the peaking PA 215. For example, the transformers 250 may provide the Driver Signals to the carrier PA 210 and the peaking PA 215. In some embodiments, the transformers 250 may be directly coupled with the carrier PA 210 and/or the peaking PA 215. For example, the transformers 250 may directly provide one or more signals to the carrier PA 210 and/or the peaking PA 215.

In some embodiments, the transformers 250 may be electrically coupled with the carrier PA 210. For example, the transformers 250 and the carrier PA 210 may be electrically coupled with one another via lines 255. In some embodiments, the lines 255 may electrically couple the transformers 250 with one or more terminals of the carrier PA 210. For example, the lines 255 may electrically couple the transformers 250 with a non-inverting terminal and an inverting terminal of the carrier PA 210. In some embodiments, the lines 255 may include at least one of cables, wires, cords, and/or among other possible physical components to electrically couple the transformers 250 with the carrier PA 210. In some embodiments, the lines 255 may include wireless connections. For example, the lines 255 may illustrate transmissions of wireless signals. FIG. 2 depicts an example of transmission of the Driver Signals, via the lines 255, from the transformer 250 to the carrier PA 210.

In some embodiments, the transformer 250 may be electrically coupled with the offset device 245. For example, the transformer 250 may be electrically coupled with the offset device 245 via lines 260. In some embodiments, the electric coupling between the transformer 250 and the offset device 245 may be similar to at least one example of electric coupling described herein. The transformers 250 may provide, via the lines 260, the Driver Signals to the offset device 245.

In some embodiments, the carrier PA 210 may receive one or more signals. For example, the carrier PA 210 may receive the Driver Signals. In some embodiments, the carrier PA 210 may provide one or more signals. For example, the carrier PA 210 may provide one or more signals to the power combiner 225. In some embodiments, the carrier PA 210 may amplify one or more signals. For example, the carrier PA 210 may receive a first Driver Signal and the carrier PA 210 may amplify the first Driver Signal. As another example, the carrier PA 210 may receive a first signal having a voltage level of 2V and the carrier PA 210 may amplifier the first signal. The signals provided by the carrier PA 210, to the power combiner 225, are shown as Carrier Signal in FIG. 2.

In some embodiments, the offset device 245 and/or offset 245 may receive one or more signals. For example, the offset device 245 may receive the Driver Signals. In some embodiments, the offset device 245 may adjust one or more signals. For example, the offset device 245 may adjust signals that are provided to the offset device 245. In some embodiments, the offset device 245 may adjust the signals by at least one of modifying, shifting, changing, and/or otherwise altering the signals. For example, the offset device 245 may perform a phase shift to adjust the one or signals. As another example, the offset device 245 may perform a 90-degree phase shift on the Driver Signals. In some embodiments, the offset device 245 may phase shift signals to offset the Driver Signal that is provided to the peaking PA 215 relative to the Driver Signal that is provided to the carrier PA 210. Signals provided by the offset device 245, to the peaking PA 215, are shown as Offset Signal in FIG. 2.

In some embodiments, the envelope detector 235 may receive one or more signals. For example, the envelope detector 235 may receive the Driver Signals. In some embodiments, the envelope detector 235 may receive the Driver Signals that are provided to the carrier PA 210. For example, the envelope detector 235 may be electrically with the lines 255. As another example, the envelope detector 235 may detect transmission of the Driver Signals via the lines 255. In some embodiments, the envelope detector 235 may be included in and/or implemented as the signal analyzer 115.

In some embodiments, the envelope detector 235 may detect a level of one or more signals. For example, the envelope detector 235 may detect a level of the Driver Signals. As another example, the envelope detector 235 may detect a voltage level of the Driver Signals. In some embodiments, the envelope detector 235 may perform similar functions to that of the signal analyzer 115.

In some embodiments, the envelope detector 235 may provide one or more signals. For example, the envelope detector 235 may provide the Envelope Signals described herein. In some embodiments, the envelope detector 235 may provide signals to one or more supply terminals. For example, the envelope detector 235 may provide signals to the supply terminals of the amplifier 120. In some embodiments, the envelope detector 235 provide signals to the summator 243. For example, the envelope detector 235 may provide the Envelope Signals to the summator 243.

In some embodiments, the envelope detector 235 may provide signals to control the peaking PA 215. For example, the envelope detector 235 may provide a first signal to turn off the peaking PA 215. As another example, the envelope detector 235 may provide a second signal to turn on the peaking PA 215. In some embodiments, the envelope detector 235 may provide signals to maintain a state of the peaking PA 215. For example, the peaking PA 215 may be on and the envelope detector 235 may provide a first signal to keep the peaking PA 215 on (e.g., maintain a state).

In some embodiments, the envelope detector 235 may control the peaking PA 215 by defining a difference between terminals of the peaking PA 215. For example, the envelope detector 235 may define a difference (e.g., a bias) between a first terminal and a second terminal of the peaking PA 215. In some embodiments, the envelope detector 235 may turn on and/or off (e.g., control) the peaking PA 215 based on the difference.

In some embodiments, the summator 243 may receive one or more signals. For example, the summator 243 may receive the Envelope Signals. In some embodiments, the summator 243 may receive the Envelope Signals from the envelope detector 235. In some embodiments, summator 243 may receive signals from the constant bias 240. For example, the constant bias 240 may include and/or be implemented as a power supply and the constant bias 240 may provide signals (e.g., power) to the summator 243.

In some embodiments, the summator 243 may combine one or more signals. For example, the summator 243 may combine the Envelope Signals with signals provided by the constant bias 240. In some embodiments, the summator 243 may combine signals by merging, integrating, uniting, and/or otherwise amalgamating signals. For example, the summator 243 may receive a first signal and a second signal. To continue this example, the first signal may include a voltage level of 2V, and the second signal may include a voltage level of 1V. In some embodiments, the summator 243 may combine the first signal and the second signal to produce a signal having a voltage level of 3V (e.g., a combination of the signals). In some embodiments, the summator 243 may combine the first signal and the second signal to produce a signal having a volage level of 1V (e.g., a difference between the signals).

In some embodiments, the summator 243 may be electrically coupled with the peaking PA 215. For example, the summator 243 may be connected with the peaking PA 215 via one or more lines. In some embodiments, the summator 243 may provide one or more signals to the peaking PA 215. For example, the summator 243 may provide a signal that is a combination of the Envelope Signals and signals provided by the constant bias 240. Signals provided by the summator 243, to the peaking PA 215, are shown as Bias Signal in FIG. 2. In some embodiments, the Bias Signals may control the peaking PA 215. For example, the Bias Signals may turn the peaking PA 215 on and/or off. In some embodiments, the summator 243 may provide the Bias Signals to one or more supply terminals of the peaking PA 215.

The offset device 245 may be electrically coupled with the peaking PA 215. For example, the offset device 245 may be electrically coupled with the peaking PA 215 via lines 265. In some embodiments, the offset device 245 may provide, via the lines 265, the Offset Signals to the peaking PA 215. In some embodiments, the Offset Signals may be provided to the peaking PA 215 in unison with the Bias Signals. For example, the offset device 245 may communicate with the envelope detector 235 to determine when to transmit the Offset Signals.

In some embodiments, the peaking PA 215 may receive one or more signals. For example, the peaking PA 215 may receive the Offset Signals. As another example, the peaking PA 215 may receive the Bias Signals. In some embodiments, the peaking PA 215 may receive, at a first point in time, a first signal and a second signal. In some embodiments, the peaking PA 215 may receive, at a first point in time, a first signal and may receive, at a second point in time, a second signal.

In some embodiments, the peaking PA 215 may provide one or more signals. For example, the peaking PA 215 may provide a first signal that is an amplification one or more signals received by the peaking PA 215. As another example, the peaking PA 215 may receive a first signal and the peaking PA 215 may provide, responsive to receiving the first signal, a second signal. In some embodiments, the peaking PA 215 may provide signals having one or more levels. For example, the peaking PA 215 may provide a first signal having a first level and/or a second level. As another example, the peaking PA 215 may provide a first signal having a first level and a second signal having a second level.

In some embodiments, the peaking PA 215 may provide signals based on the difference defined by the envelope detector 235. For example, the difference may define and/or establish a bias between supply terminals of the peaking PA 215 and the bias may dictate a level of a signal provided by the peaking PA 215. In some embodiments, the peaking PA 215 may provide a signal having a first level in response to the difference being smaller than a predetermined value. For example, the bias may be less than 1V (e.g., a predetermined value) and the peaking PA 215 may provide a signal having a voltage level of 0V (e.g., a first level) in response to the bias being less than 1V. As another example, the peaking PA 215 may provide a signal that is less than its gain factor in response to the bias being less than a predetermined value.

In some embodiments, the peaking PA 215 may provide a signal having a second level in response to the difference being larger than a predetermined value. For example, the peaking PA 215 may provide an amplified signal in response to a bias (e.g., a difference) between terminals of the peaking PA 215 being larger than a predetermined value. In some embodiments, the peaking PA 215 may provide an amplified signal of at least one of the signals described herein. For example, the peaking PA 215 may provide an amplified signal of the Driver Signals. As another example, the peaking PA 215 may provide an amplified signal of the Offset Signals.

In some embodiments, the peaking PA 215 may provide signals to the impedance inverter 220. For example, the peaking PA 215 may be electrically coupled, via lines 270, with the impedance inverter 220. To continue this example, the peaking PA 215 may provide signals to the impedance inverter 220 via the lines 270. Signals provided, to the impedance inverter 220, by the peaking PA 215 are shown as Peaking Signal in FIG. 2.

In some embodiments, the impedance inverter 220 may receive one or more signals. For example, the impedance inverter 220 may receive the Peaking Signals via the lines 270. In some embodiments, the impedance inverter 220 may invert one or more signals. For example, the impedance inverter 220 may receive a first signal having a first value and the impedance inverter 220 may invert the first signal from the first value to a second value. In some embodiments, the impedance inverter 220 may invert signals by producing a signal that is opposite of and/or a reciprocal of an input signal. For example, the impedance inverter 220 may receive a first signal having a voltage level of 2V and the impedance inverter 220 may provide a signal having a voltage level of negative 2V (e.g., -2V). In some embodiments, the impedance inverter 220 may receive one or more signals having one or more amounts of resistance and/or impedance. For example, the impedance inverter 220 may receive a first signal having a voltage level of 0V. To continue this example, the first signal having a voltage level of 0V may result in an amount of resistance (associated with the first signal) being equivalent to infinity. In some embodiments, the impedance inverter 220 may invert the amount of resistance from infinity (e.g., a first value) to zero (e.g., a second value). In some embodiments, the impedance inverter 220 may invert an amount of resistance associated with the Peaking Signals. For example, the impedance inverter 220 may invert an amount of resistance, for a Peaking Signal, from a first value to a second value.

In some embodiments, the impedance inverter 220 may receive the Peaking Signals prior to the power combiner 225 receiving the Peaking Signals. For example, the impedance inverter 220 may receive, from the peaking PA 215, the Peaking Signals, and the impedance inverter 220 may provide the Peaking Signals to the power combiner 225.

In some embodiments, the amount of resistance associated with the Peaking Signals may impact and/or adjust a value and/or a level of one or more signals described herein. For example, the amount of resistance of the Peaking Signals may impact the Output Signals described herein. In some embodiments, the amount of resistance associated with the Peaking Signals may impact the signals by adjusting an amount of resistance that is experienced by one or more signals. For example, the Carrier PA 210 may provide a first Carrier Signal having a first amount of current and an amount of resistance, experienced by the first Carrier Signal, may dictate a level (e.g., an amount of power of the Carrier Signal).

In some embodiments, the impedance inverter 220 may provide one or more signals. For example, the impedance inverter 220 may provide signals to the power combiner 225. In some embodiments, the impedance inverter 220 may provide inverted signals. For example, the impedance inverter 220 may provide a signal that includes and/or indicates the Peaking Signals. As another example, the impedance inverter 220 may provide inverted signals of the Peaking Signals. Signals provided, by the impedance inverter 220, to the power combiner 225 are shown as Inverted Signal in FIG. 2. In some embodiments, the Inverted Signals may be an inversion of an amount of resistance associated with the Peaking Signals.

In some embodiments, the power combiner 225 may receive one or more signals. For example, the power combiner 225 may receive the Carrier Signals. In some embodiments, the power combiner 225 may receive the Carrier Signals via lines 280. For example, the power combiner 225 may be electrically coupled, via the lines 280, with the carrier PA 210. In some embodiments, the power combiner 225 may receive the Inverted Signals. For example, the power combiner 225 may receive the Inverted Signals via lines 275.

In some embodiments, the power combiner 225 may provide one or more signals. For example, the power combiner 225 may provide the Output Signals described herein. In some embodiments, the power combiner 225 may provide signals having one or more levels. For example, the power combiner 225 may provide a first signal having a first level. In some embodiments, the power combiner 225 may provide signals based on the Carrier Signals and/or the Peaking Signals. For example, the power combiner 225 may provide a first Output Signal that has a first level, and the first level may be based on the Carrier Signal and/or the Peaking Signals.

In some embodiments, the Output Signals may be a combination of the Carrier Signals and the Peaking Signals. For example, the power combiner 225 may receive the Carrier Signals and the Peaking Signals. To continue this example, the levels (e.g., an amount of power) of the Carrier Signals and the Peaking Signals may be provided and/or applied to a load (e.g., the resistive element 230). Stated otherwise, an amount of current associated with the Carrier Signals and the Peaking signals may be provided to the resistive element 230 (e.g., a load). The amount of current that is provided to the resistive element 230 may define and/or generate one or more levels of the Output Signals.

As a non-limiting example, the Carrier PA 210 may receive, via the lines 255, a first Driver Signal. The first Driver Signal may include a voltage level of 5V (e.g., a first level). To continue this example, the offset device 245 and the Envelope detector 235 may receive the first Driver Signal. The offset device 245 may provide, via the lines 265, a first Offset Signal to the peaking PA 215. The envelope detector 235 may detect that the first Driver Signal has the first level. To continue this example, the envelope detector 235 may control the peaking PA 215. The envelope detector 235 may turn off the peaking PA 215 (e.g., control) in response to the first Driver Signal having the first level. To continue this example, the carrier PA 210 may provide a first Carrier Signal. The first Carrier Signal may be based on the first Driver Signal. To continue this example, the peaking PA 215 may provide, in response to envelope detector 235 turning off the peaking PA 215, a Peaking Signal having a voltage level of 0V (e.g., a first level). The Peaking Signal may be provided to the impedance inverter 220. To continue this non-limiting example, the Peaking Signal may be associated with an infinite amount of resistance (based on the Peaking Signal having a voltage level of 0V). The impedance inverter 220 may invert the Peaking Signal. To continue this example, the impedance inverter 220 may invert the Peaking Signal from an infinite amount of resistance to zero resistance (e.g., an Inverted Signal). The power combiner 225 may receive the first Carrier Signal and the Inverted Signal. To continue this non-limiting example, the power combiner 225 may provide a first Output Signal. The first Output Signal may be based on a level of the first Carrier Signal. To continue this non-limiting example, the power combiner 225 may apply the first Carrier Signal to the resistive element 230.

In some embodiments, at least one of the carrier PA 210 and/or the Peaking PA 215 may be electrically coupled with the resistive element 230. For example, the power combiner 225 may electrically couple (either directly and/or indirectly) the carrier PA 210 with the resistive element 230. In some embodiments, the impedance inverter 220 may adjust an amount of resistance that is experienced by the carrier PA 210 from a first level to a second level. For example, when the Inverted Signal includes an impedance amount of zero, the carrier PA 210 may experience a first amount of resistance (e.g., an amount of resistance associated with the resistive element 230). As another example, when the Inverted Signals includes an impedance amount that is larger than zero, the carrier PA 210 may experience a second amount of resistance (e.g., an amount that is different than the first amount of resistance). In some embodiments, the amount of resistance experienced by the carrier PA 210 may dictate one or more levels of the Carrier Signals and/or the Output Signals. For example, the carrier PA 210 may provide a first Carrier Signal having a first level and a first Output Signal may have a first level when the first level of the first Carrier Signal is provided to the resistive element 230. As another example, the first Output Signal may have a second level when the first level of the first Carrier Signal is provided to only a portion of the resistive element. In some embodiments, the Output Signals may have one or more first values when the carrier PA 210 experiences all of the resistive element 230. For example, an amount of current associated with the Carrier Signals may be applied to the resistive element 230.

In some embodiments, the one or more signals described herein may have one or more levels. For example, the peaking PA 215 may provide signals that have one or more levels. In some embodiments, the peaking PA 215 may provide one or more signals having a first level. For example, the peaking PA 215 may provide a first signal that has a voltage level of 5V (e.g., a first level). As another example, the peaking PA 215 may provide a second signal that has a voltage level of 2V (e.g., a second level). In some embodiments, the carrier PA 210 may provide the Carrier Signals based on the Driver Signal. For example, the Carrier Signals may be an amplified signal that is based on the Driver Signal. Stated otherwise, the carrier PA 210 may receive the Driver Signals and the carrier PA 210 may provide, based on a level of the Driver Signals, an amplified signal (e.g., a Carrier Signal).

In some embodiments, the levels and/or values of the signals described herein may be different. For example, the carrier PA 210 may provide a first Carrier Signal having a voltage level of 3V (e.g., a first level). As another example, the peaking PA 215 may provide a first Peaking Signal having a voltage level of 5V (e.g., a first level). In some embodiments, the first level of the first Peaking Signal may be different than the first level of the first Carrier Signal. For example, the first level of the first Peaking Signal may be larger than the first level of the first Carrier Signal. In some embodiments, the peaking PA 215 may have a gain factor that is larger than a gain factor of the carrier PA 210 (e.g., the peaking PA 215 may provide an amplified signal that is larger than an amplified signal provided by the carrier PA 210).

In some embodiments, the levels and/or values of the signals described herein may change. For example, the peaking PA 215 may provide a first Peaking Signal having a first level in response to the Bias Signal being larger than the predetermined difference. To continue this example, the first level of the first Peaking Signal may be larger than a first level of a first Carrier Signal. In some embodiments, the carrier PA 210 may provide a Carrier Signal having a first level. In some embodiments, the Carrier Signals may be larger than the Peaking Signals. For example, the carrier PA 210 may provide a signal having a voltage level of 5V. To continue this example, the peaking PA 215 may provide, in response to the Bias Signal being smaller than the predetermined threshold, a Peaking Signal having a voltage level of 0V (e.g., the peaking PA 215 is off).

In some embodiments, the one or more signals described herein may be provided at one or more time intervals. For example, the peaking PA 215 may receive the Offset Signals at a first point in time and the carrier PA 210 may also receive the Driver Signals at the first point in time. As another example, the carrier PA 210 may receive the Driver Signals at a first point in time and the envelope detector 235 may receive the Driver Signals at a second point in time.

In some embodiments, at least one component of the schematic block diagram 200 may be positioned and/or located between one or more second components. For example, FIG. 2 depicts an example of the impedance inverter 220 located between the peaking PA 215 and the power combiner 225. The impedance inverter 220, as illustrated in FIG. 2, is also shown to be in series to the peaking PA 215 and the power combiner 225.

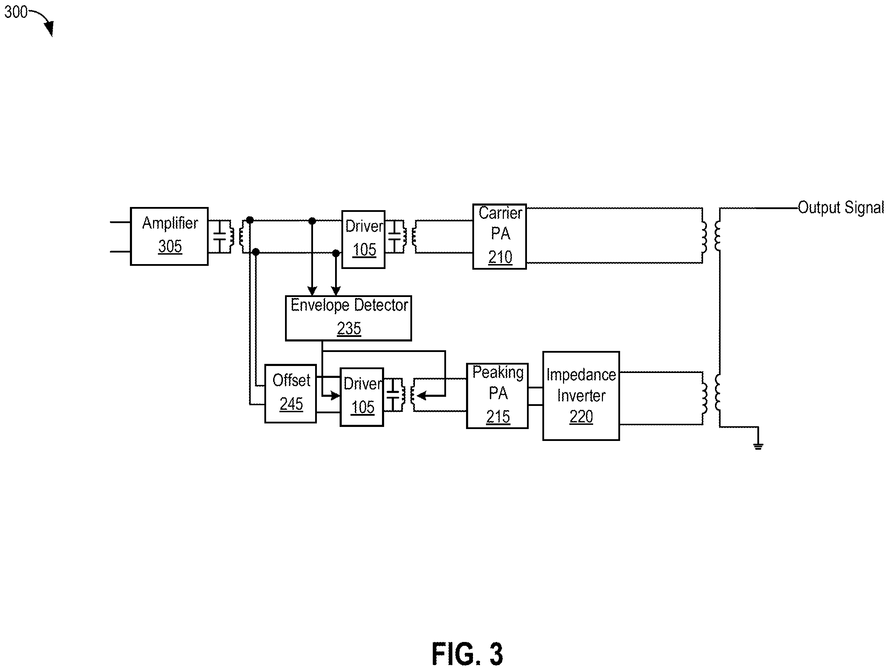

FIG. 3 depicts a schematic block diagram 300, according to some embodiments. In some embodiments, the schematic block diagram 300 may include at least one component of the schematic block diagram 200. In some embodiments, at least one of the schematic block diagram 200 and/or the schematic block diagram 300 may refer to and/or include a first configuration and/or a first orientation of components. For example, in the schematic block diagram 200, signals may be provided to input terminals of devices. As another example, in the schematic block diagram 300, signals may be provided to output signals.

In some embodiments, the schematic block diagram 300 may include one or more systems, devices, and/or components of the system 100. For example, the schematic block diagram 300 may include the amplifiers 120. In some embodiments, the system 100 may include and/or be implemented as the schematic block diagram 300. In some embodiments, at least one device and/or component of the schematic block diagram 300 may be included in and/or implemented within the system 100. In some embodiments, systems, devices, and/or components of the schematic block diagram 300 may be added, removed, integrated, separated, rearranged, relocated, and/or replaced.

The schematic block diagram 300 may include at least one amplifier 305, in some embodiments. In some embodiments, the amplifier 305 may include at least one amplifier described herein. For example, the amplifier 305 may include the amplifiers 120. In some embodiments, the amplifier 305 may refer to and/or include a pre-amplifier. As shown in FIG. 3, the schematic block diagram 300 includes a first driver 105 and a second driver 105. In some embodiments, the first driver 105 may drive the carrier PA 210 and the second driver 105 may drive the peaking PA 215. For example, the first driver 105 may provide a first Driver Signal to the carrier PA 210 and the second driver 105 may provide a second Driver Signal to the peaking PA 215. In some embodiments, the schematic block diagram 300 may refer to and/or include multi-stage amplification.

As shown in FIG. 3, the envelope detector 235 is shown to receive signals that correspond to input signals provided to the first driver 105. In some embodiments, the envelope detector 235 may provide signals to input terminals of the second driver 105. For example, the envelope detector 235 may control a bias between terminals of the second driver 105. In some embodiments, the envelope detector 235 may provide signals to input terminals of the peaking PA 215. For example, the envelope detector 235 may provide the Envelope Signals described herein to the peaking PA 215.

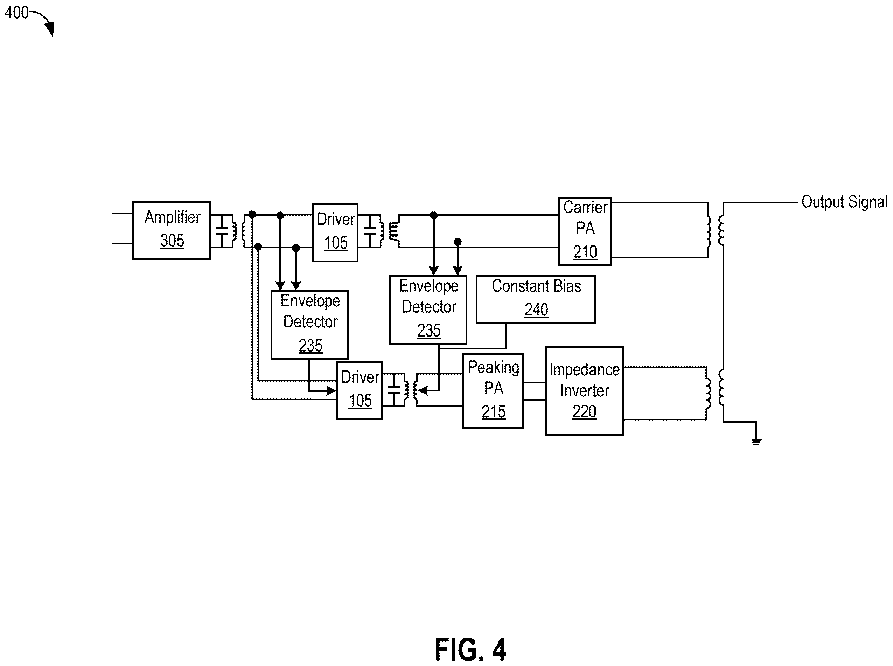

FIG. 4 depicts a schematic block diagram 400, according to some embodiments. In some embodiments, the schematic block diagram 400 may include one or more systems, devices, and/or components of the system 100. In some embodiments, the schematic block diagram 400 may include an implementation of the system 100. In some embodiments, at least one device and/or component of the schematic block diagram 400 may be included in the system 100. In some embodiments, systems, devices, and/or components of the schematic block diagram 400 may be added, removed, integrated, separated, rearranged, relocated, and/or replaced.

As shown in FIG. 4, the envelope detector 235 may receive one or more first signals to indicate inputs to the first driver 105 and one or more second signals to indicate inputs to the carrier PA 210. For example, the envelope detector 235 may be electrically coupled with input terminals of the first driver 105 and the envelope detector 235 may detect one or more signals that are provided to the input terminals of the first driver 105.

In some embodiments, the envelope detector 235 may control the second driver 105 separate from the peaking PA 215. For example, the envelope detector 235 may control the second driver 105 based on the signals provided to the inputs of the first driver 105. As another example, the envelope detector 235 may control the peaking PA 215 based on the signals output by the carrier PA 210. In some embodiments, linearity of the Output Signals may be controlled and/or adjusted in response to the envelope detector 235 separately controlling the second driver 105 and the peaking PA 215.

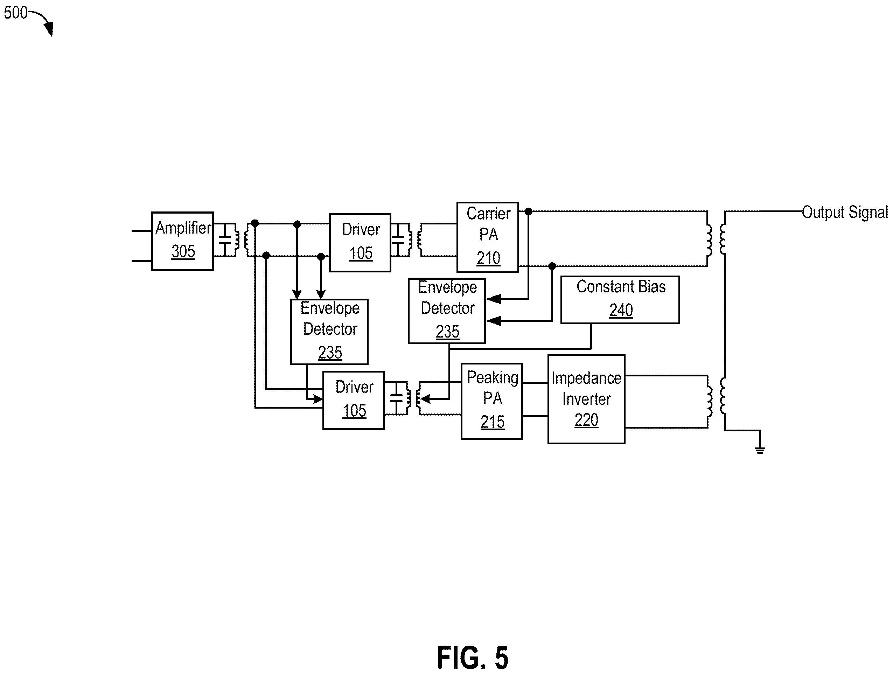

FIG. 5 depicts a schematic block diagram 500, according to some embodiments, in some embodiments, the schematic block diagram 500 may include one or more systems, devices, and/or components of the system 100. In some embodiments, the schematic block diagram 500 may include an implementation of the system 100. In some embodiments, systems, devices, and/or components of the schematic block diagram 500 may be added, removed, integrated, separated, rearranged, relocated, and/or replaced.

As shown in FIG. 5, the envelope detector 235 may receive one or more first signals to indicate inputs to the first driver 105 and the envelope detector 235 may receive one or more second signals to indicate outputs of the carrier PA 210. For example, the envelope detector 235 may be electrically coupled with output terminals of the carrier PA 210 and the envelope detector 235 may detect one or more signals that are provided by the carrier PA 210.

In some embodiments, the schematic block diagram 500 may include feedback configuration. For example, the outputs of the carrier PA 210 may be used, by the envelope detector 235, to control the peaking PA 215. In some embodiments, the envelope detector 235 may use the output signals of the carrier PA 210 to detect saturation of the carrier PA 210 (e.g., output signals provided by the carrier PA 210 are no longer being amplified based on a gain factor of the carrier PA 210). In some embodiments, a transmission strength of the Carrier Signals may fluctuate and/or change. For example, a Voltage Standing Wave Ratio (VSWR) of the Carrier Signals may change based on one or more loads. In some embodiments, the envelope detector 235 may control a bias of the peaking PA 215 to control when the peaking PA 215 turns on and/or off. The envelope detector 235 may adjust a linearity sensitivity for the carrier PA 210 by controlling the bias of the peaking PA 215.

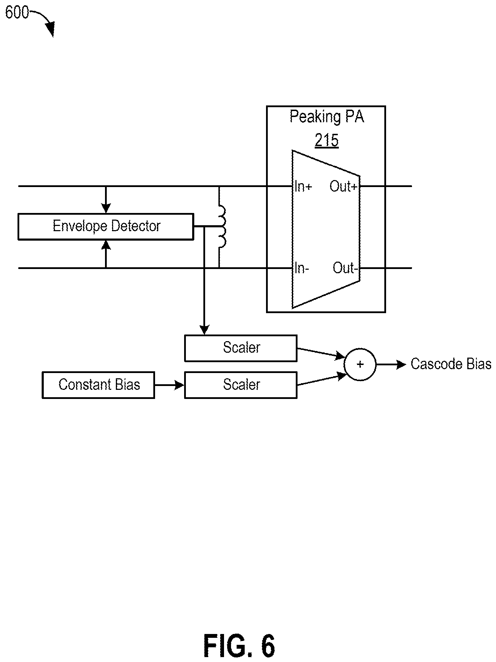

FIG. 6 depicts a schematic block diagram 600, according to some embodiments. In some embodiments, the schematic block diagram 600 may include one or more systems, devices, and/or components of the system 100. In some embodiments, the schematic block diagram 600 may include an implementation of the system 100. In some embodiments, systems, devices, and/or components of the schematic block diagram 600 may be added, removed, integrated, separated, rearranged, relocated, and/or replaced. In some embodiments, the schematic block diagram 600 may include at least one component and/or device described herein. For example, the schematic block diagram 600 may include at least one component of the schematic block diagram 200. As shown in FIG. 6, the envelope detector 235 receives signals corresponding to Driver Signals that are provided to terminals (shown as In+ and In- in FIG. 6) of the peaking PA 215. In some embodiments, the envelope detector 235 may provide signals to control a cascode bias of the peaking PA 215.

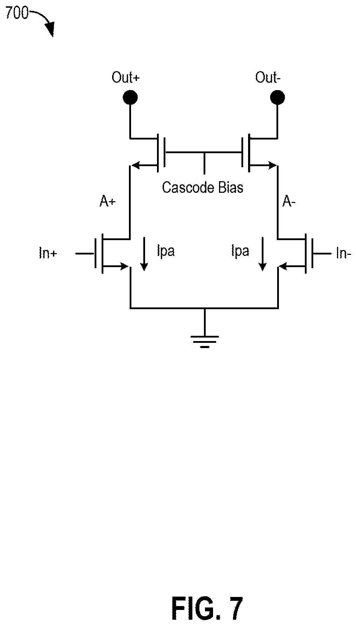

FIG. 7 is a schematic block diagram 700, according to some embodiments. In some embodiments, the schematic block diagram 700 may include and/or be implemented as the peaking PA 215. As shown in FIG. 7, the cascode bias is shown to define and/or represent a difference between terminals of the peaking PA 215. In some embodiments, the peaking PA 215 may provide one or more signals having a first level in response to the cascode bias being above a given value. In some embodiments, the peaking PA 215 may be turned off in response to the cascode bias being below a given value. The cascode bias between terminals of an amplifier may impact performance and/or reliability of the amplifier. For example, drain nodes (e.g., A+ and A- as shown in FIG. 7) may cause variation in the cascode bias of amplifiers. In some embodiments, the envelope detector 235 may control and/or adjust the cascode bias to maintain a difference between the terminals of the peaking PA 215 to reduce variation in the peaking PA 215.

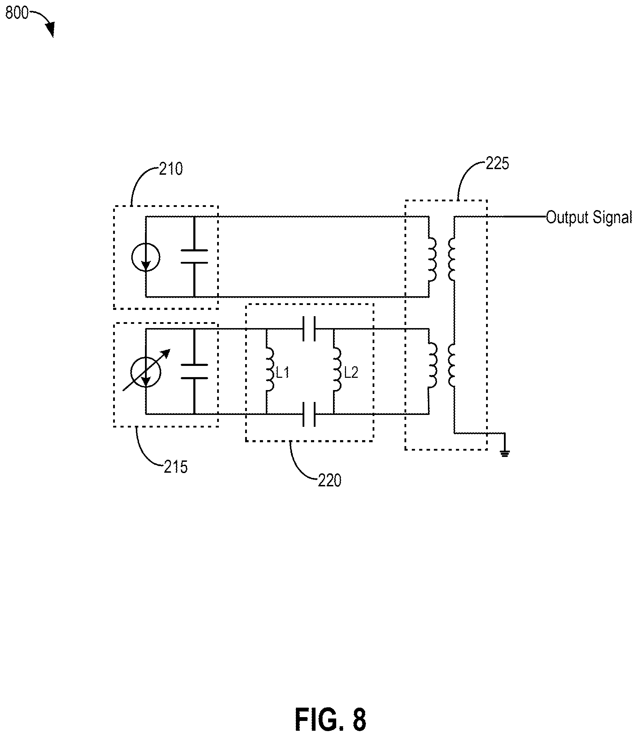

FIG. 8 depicts a schematic block diagram 800, according to some embodiments. In some embodiments, the schematic block diagram 800 may include at least one component and/or device of the schematic block diagram 200. For example, the schematic block diagram 800, as shown in FIG. 8, includes the carrier PA 210, the peaking PA 215, the impedance inverter 220, and the power combiner 225. In some embodiments, at least one device and/or component of the schematic block diagram 800 may be included in and/or implemented within the system 100. In some embodiments, systems, devices, and/or components of the schematic block diagram 800 may be added, removed, integrated, separated, rearranged, relocated, and/or replaced. For example, a device that is shown to include two capacitors may be modified to include only one capacitor.

In some embodiments, the impedance inverter 220 may include at least one capacitor and/or at least one inductor. For example, the impedance inverter 220 is shown in FIG. 8 to include two capacitors and two inductors (shown as L1 and L2). In some embodiments, the L2 inductor may be combined with and/or merged with a transformer of the power combiner 225. For example, the L2 inductor may be combined with the transformer that is electrically coupled with the impedance inverter 220. FIG. 8 depicts an example of the impedance inverter 220 implemented as a high pass type device.

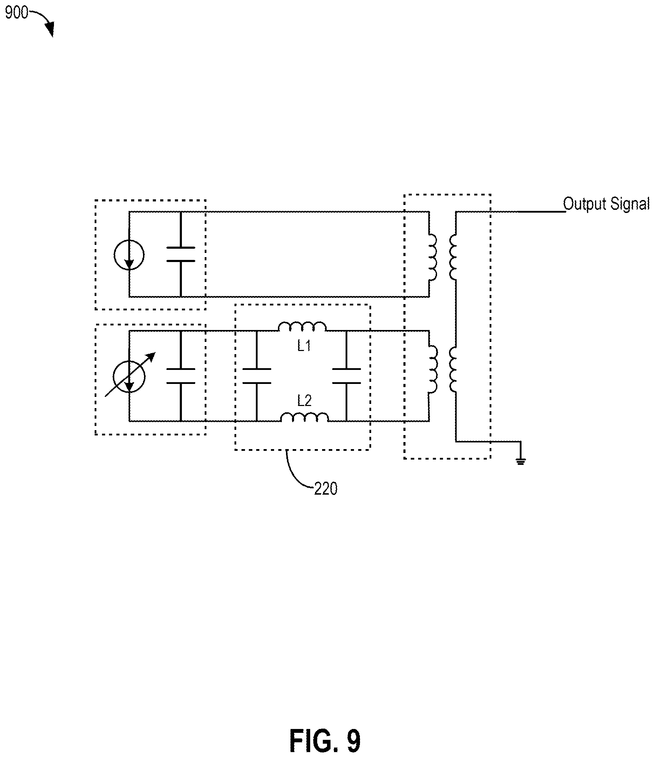

FIG. 9 depicts a schematic block diagram 900, according to some embodiments. In some embodiments, the schematic block diagram 900 may include at least one component and/or device of the schematic block diagram 200. For example, the schematic block diagram 900, as shown in FIG. 9, includes the impedance inverter 220. In some embodiments, at least one device and/or component of the schematic block diagram 900 may be included in and/or implemented within the system 100. In some embodiments, systems, devices, and/or components of the schematic block diagram 900 may be added, removed, integrated, separated, rearranged, relocated, and/or replaced. For example, a device that is shown to include two capacitors may be modified to include only one capacitor. FIG. 9 depicts an example of the impedance inverter 220 implemented as a low pass type device. In some embodiments, the L1 and L2 inductors, as shown in FIG. 9, may be combined and/or modified such that the impedance inverter 220 includes a single inductor.

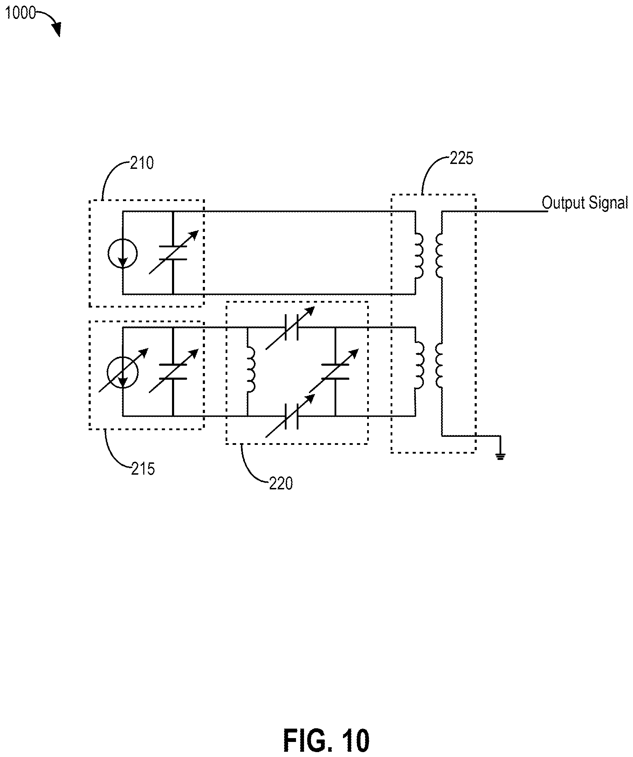

FIG. 10 depicts a schematic block diagram 1000, according to some embodiments. In some embodiments, the schematic block diagram 1000 may include at least one component and/or device of the schematic block diagram 200. For example, the schematic block diagram 1000 may include the carrier PA 210, the peaking PA 215, the impedance inverter 220, and the power combiner 225. As shown in FIG. 10, the impedance inverter 220 is illustrated as being implemented as a high pass filter. In some embodiments, systems, devices, and/or components of the schematic block diagram 1000 may be added, removed, integrated, separated, rearranged, relocated, and/or replaced. For example, a device that is shown to include two capacitors may be modified to include only one capacitor.

In some embodiments, L2 may be integrated and/or merged with at least one transformer of the power combiner 225. In some embodiments, at least one system, device, and/or component described herein may include a configurable and/or tunable element. For example, the carrier PA 210, the peaking PA 215, and the impedance inverter 220 may include one or more tuning capacitors. FIG. 10 depicts an example of the carrier PA 210 and the peaking PA 215 each including a tuning capacitor and an example of the impedance inverter 220 including three tuning capacitors. In some embodiments, an amount and/or a number of tunning components may be modified, adjusted, updated, and/or otherwise changed. For example, the carrier PA 210 may include two tunning capacitors. As another example, the impedance inverter 220 may include a single tunning capacitor.

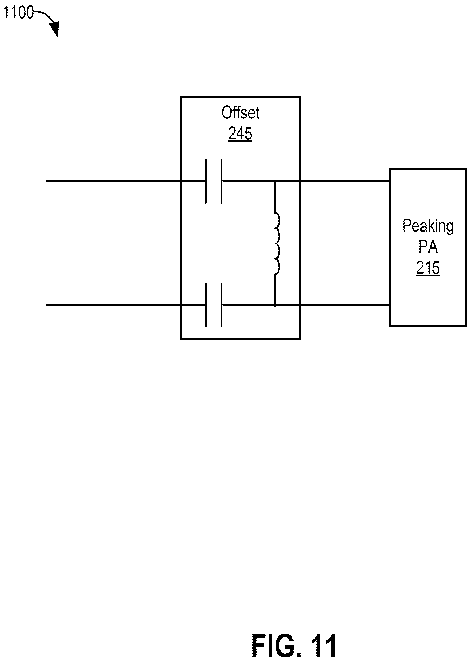

FIG. 11 depicts a schematic block diagram 1100, according to some embodiments. In some embodiments, the schematic block diagram 1100 may include at least one component and/or device of the schematic block diagram 200. For example, the schematic block diagram 1100, as shown in FIG. 11, includes the offset 245, and the peaking PA 215. In some embodiments, at least one device and/or component of the schematic block diagram 1100 may be included in and/or implemented within the system 100.

In some embodiments, systems, devices, and/or components of the schematic block diagram 1100 may be added, removed, integrated, separated, rearranged, relocated, and/or replaced. For example, a device that is shown to include an inductor may be modified to include two inductors. In some embodiments, the schematic block diagram 1100 may represent and/or indicate a circuit equivalent diagram. In some embodiments, the offset 245 and/or one or more components thereof may offset at least one of the various signals described herein. For example, the offset 245 may phase shift the Driver signals by 90 degrees.

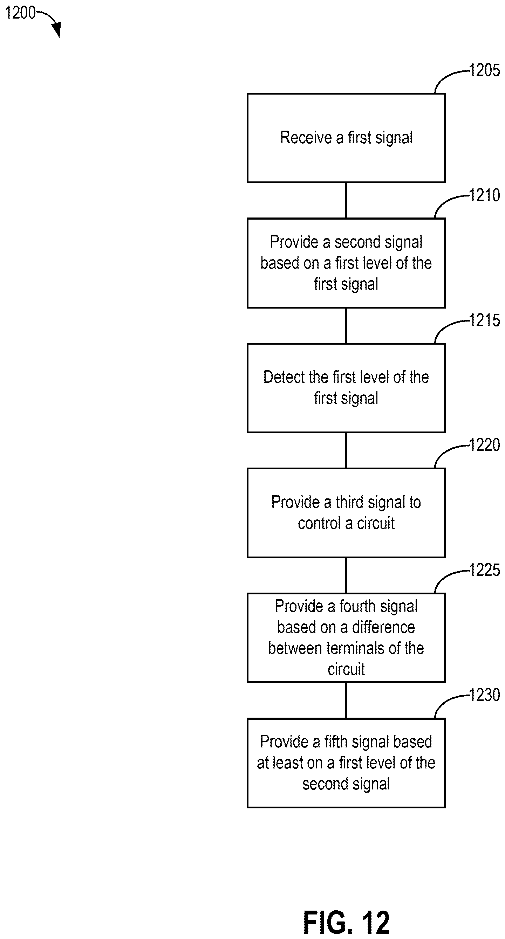

FIG. 12 depicts a block diagram of a process 1200 of controlling an amplifier, according to some embodiments. In some embodiments, at least one of the various systems, devices, and/or components described herein may perform one or more steps of the process 1200. For example, the device 110 may perform at least one step of the process 1200. In some embodiments, at least one step of the process 1200 may be repeated, reproduced, and/or otherwise performed again. For example, a step that includes receiving a first signal may be repeated responsive to a device transmitting a subsequent first signal.

At step 1205, a first signal may be received. For example, the first signal may be received by the device 110. In some embodiments, the first signal may refer to and/or include at least one of the various signals described herein. For example, the first signal may refer to the Driver signals described herein. In some embodiments, the device 110 may receive the first signal from the driver 105. For example, the device 110 may receive the first signal responsive to the driver 105 transmitted the first signal.

In some embodiments, the first signal may indicate a first amount of power. For example, the first signal may have a first level to indicate a first amount of power and the first signal may have a second level to indicate a second amount of power. In some embodiments, the first amount of power may indicate at least one of the various protocols described herein. For example, the first amount of power may indicate communication via Bluetooth.

In some embodiments, the device 110 may receive the first signal responsive to the driver 105 receiving a communication signal. For example, the driver 105 may receive a signal for transmission using Bluetooth and the driver 105 may provide a signal (e.g., the first signal) to indicate transmission using Bluetooth.

At step 1210, a second signal may be provided, in some embodiments. For example, the second signal may be provided by the carrier PA 210. In some embodiments, the second signal may be provided responsive to receipt of the first signal. For example, the second signal may be provided responsive to a device having received the first signal. In some embodiments, the carrier PA 210 may provide the second signal to the power combiner 225. In some embodiments, the second signal may refer to and/or include at least one of the various signals described herein. For example, the second signal may include the Carrier Signals described herein.

In some embodiments, the second signal may have one or more levels. For example, the second signal may have a first level and a second level. In some embodiments, the levels of the second signal may be based on the first signal received in step 1205. For example, the second signal may have a first level based one or more levels of the first signal.

At step 1215, the first level of the first signal may be detected. For example, the envelope detector 235 may detect that the first signal, received in step 1205, has the first level. In some embodiments, the envelope detector 235 may receive the first signal. For example, the driver 105 may provide the first signal to the envelope detector 235. In some embodiments, the envelope detector 235 may determine that the driver 105 provided the first signal. The envelope detector 235 may detect, responsive to determining that the driver 105 provided the first signal, the first level of the first signal.

In some embodiments, the envelope detector 235 may detect that the first signal includes the first level responsive to the envelope detector monitoring an amount of power that is transmitted via the lines 255. For example, the envelope detector 235 may detect that the first signal includes the first level responsive to the envelope detector 235 detecting transmission of a first amount of power via the lines 255.

At step 1220, a third signal may be provided, in some embodiments. For example, the envelope detector 235 may provide the third signal. In some embodiments, the third signal may be provided to the peaking PA 215. For example, the envelope detector 235 may provide the third signal to the peaking PA 215. In some embodiments, the third signal may control one or more circuits. For example, the third signal may control the peaking PA 215. In some embodiments, the third signal may control one or more circuits by at least one of turning on and/or turning off the one or more circuits.

In some embodiments, the third signal may refer to and/or include at least one of the various signals described herein. For example, the third signal may include the Bias signals described herein. In some embodiments, the third signal may control the one or more circuits by defining a difference between one or more terminals. For example, the third signal may define a bias (e.g., a difference) between terminals of the peaking PA 215.

At step 1225, a fourth signal may be provided. For example, the peaking PA 215 may provide the fourth signal. In some embodiments, the peaking PA 215 may provide the fourth signal to the power combiner 225. In some embodiments, the fourth signal may refer to and/or include at least one of the various signals described herein. For example, the fourth signal may include the Peaking signals describe herein. In some embodiments, the fourth signal may have one or more levels. For example, the fourth signal may a first level in response to the difference being smaller than a predetermined value. Stated otherwise, the difference defined, in step 1220, by the envelope detector 235 may result in the fourth signal having a first level.

In some embodiments, the fourth signal may have a first level in response to the bias between terminals of the peaking PA 215 being smaller than a predetermined threshold. In some embodiments, the peaking PA 215 may be off responsive to the bias between terminals of the peaking PA 215 being smaller than the predetermined threshold. For example, the first level of the fourth signal may be 0 V (e.g., the peaking PA is off). In some embodiments, the fourth signal have a second level in response to the difference being larger than the predetermined value. For example, the peaking PA 215 may be on, and the peaking PA 215 may provide an amplified signal (e.g., the fourth signal having the second level).

At step 1230, a fifth signal may be provided, in some embodiments. For example, the power combiner 225 may provide the fifth signal. In some embodiments, the power combiner 225 may provide the fifth signal to one or more of the various systems, devices, and/or components described herein. In some embodiments, the fifth signal may have one or more levels. For example, the fifth signal may have a first level and a second level.

In some embodiments, the fifth signal may have the first level based at least on the second signal. For example, the fifth signal may be an amplification of the second signal. In some embodiments, the fifth signal may have the first level in response to the peaking PA 215 having been turned off. For example, when the peaking PA 215 is off, the power combiner 225 may only receive a signal from the carrier PA 210.

In some embodiments, the fifth signal may have the second level based on the second signal and the second level of the fourth signal. For example, the fifth signal may be an amplification of the second signal and the fourth signal. In some embodiments, the second level of the fifth signal may be larger than the first level of the fifth signal. For example, the second level of the fifth signal may include and/or indicate the second signal and the second level of the fourth signal. As another example, the first level of the fifth signal may only indicate the second signal.

In some embodiments, the fifth signal may include a percentage and/or a proportion of the second signal and the fourth signal. For example, the fifth signal may be based on a percentage of the resistive element 230 that is experienced by the second signal and/or the fourth signal. In some embodiments, when the peaking PA 215 is off, the second signal may experience all of the resistive element 230. For example, the resistive element 230 may be a 50 Ohm resistor and the second signal may experience 50 Ohms of resistance. In some embodiments, when the peaking PA 215 is on, the amount of resistance experienced by the second signal and the fourth signal may be split. For example, the resistive element 230 may be a 40 Ohm resistor and both the second signal and the fourth signal may experience 20 Ohms of resistance (e.g., both experience half of the resistive element 230). While some of the examples discussing one or more adjustments to resistance have been described with respect to one or more amounts of resistance (e.g., ohms), one or more adjustments to resistance may also include adjusts to an amount of inductance and/or one or more adjustments to an amount of capacitance. For example, the resistive element 230 may include a capacitive element and an amount of capacitance experienced may be changed and/or adjusted.

In some embodiments, the carrier PA 210 may provide a continuous and/or constant signal. For example, the Carrier signals described herein may have a voltage level of 2 V in response to the carrier PA 210 having received a Driver signal having a voltage level 1 V. In some embodiments, the Carrier signals being constant may refer to the voltage level of the carrier signals only changing in response to changes in the Driver signals.

The hardware systems described herein may be implemented in many different ways and in many different combinations of hardware and software and circuit designs. For example, all or parts of the implementations may be circuitry that includes an instruction processor, such as a Central Processing Unit (CPU), microcontroller, or a microprocessor; an Application Specific Integrated Circuit (ASIC), Programmable Logic Device (PLO), or Field Programmable Gate Array (FPGA); or circuitry that includes discrete logic or other circuit components, including analog circuit components, digital circuit components or both; or any combination thereof. The circuitry may include discrete interconnected hardware components and/or may be combined on a single integrated circuit die, distributed among multiple integrated circuit dies, or implemented in a Multiple Chip Module (MCM) of multiple integrated circuit dies in a common package, as examples. In some embodiments, the circuitry can be provided on one or more integrated circuit dies in an integrated circuit package. The integrated circuit package can be a combination of two or more packages in some embodiments.

The circuitry may further include or access instructions (e.g., software or firmware) for execution by the circuitry. The instructions may be stored in a tangible storage medium that is other than a transitory signal, such as a flash memory, a Random Access Memory (RAM), a Read Only Memory (ROM), an Erasable Programmable Read Only Memory (EPROM); or on a magnetic or optical disc, such as a Compact Disc Read Only Memory (CDROM), Hard Disk Drive (HOD), or other magnetic or optical disk; or in or on another machine-readable medium. A product, such as a computer program product, may include a storage medium and instructions stored in or on the medium, and the instructions when executed by the circuitry in a device may cause the device to implement any of the processing described above or illustrated in the drawings.

The implementations may be distributed as circuitry among multiple system components, such as among multiple processors and memories, optionally including multiple distributed processing systems. Parameters, databases, and other data structures may be separately stored and managed, may be incorporated into a single memory or database, may be logically and physically organized in many different ways, and may be implemented in many different ways, including as data structures such as linked lists, hash tables, arrays, records, objects, or implicit storage mechanisms. Programs may be parts (e.g., subroutines) of a single program, separate programs, distributed across several memories and processors, or implemented in many different ways, such as in a library, such as a shared library (e.g., a Dynamic Link Library (DLL)). The DLL, for example, may store instructions that perform any of the processing described above or illustrated in the drawings, when executed by the circuitry.

The term "coupled" and variations thereof includes the joining of two members directly or indirectly to one another. The term "electrically coupled" and variations thereof includes the joining of two members directly or indirectly to one another through conductive materials (e.g., metal or copper traces). Such joining may be stationary (e.g., permanent or fixed) or moveable (e.g., removable or releasable). Such joining may be achieved with the two members coupled directly with or to each other, with the two members coupled with each other using a separate intervening member and any additional intermediate members coupled with one another, or with the two members coupled with each other using an intervening member that is integrally formed as a single unitary body with one of the two members. If "coupled" or variations thereof are modified by an additional term (e.g., directly coupled), the generic definition of "coupled" provided above is modified by the plain language meaning of the additional term (e.g., "directly coupled" means the joining of two members without any separate intervening member), resulting in a narrower definition than the generic definition of "coupled" provided above. Such coupling may be mechanical, electrical, or fluidic.

The foregoing outlines features of several embodiments so that those skilled in the art may better understand the aspects of the present disclosure. Those skilled in the art should appreciate that they may readily use the present disclosure as a basis for designing or modifying other processes and structures for carrying out the same purposes and/or achieving the same advantages of the embodiments introduced herein. Those skilled in the art should also realize that such equivalent constructions do not depart from the spirit and scope of the present disclosure, and that they may make various changes, substitutions, and alterations herein without departing from the spirit and scope of the present disclosure.

It should be noted that certain passages of this disclosure can reference terms such as "first" and "second" in connection with subsets of transmit spatial streams, sounding frames, response, and devices, for purposes of identifying or differentiating one from another or from others. These terms are not intended to merely relate entities (e.g., a first device and a second device) temporally or according to a sequence, although in some cases, these entities can include such a relationship. Nor do these terms limit the number of possible entities that can operate within a system or environment. It should be understood that the systems described above can provide multiple ones of any or each of those components and these components can be provided on either a standalone machine or, in some embodiments, on multiple machines in a distributed system. In addition, the systems and methods described above can be provided as one or more computer-readable programs or executable instructions embodied on or in one or more articles of manufacture, e.g., a floppy disk, a hard disk, a CD-ROM, a flash memory card, a PROM, a RAM, a ROM, or a magnetic tape. The programs can be implemented in any programming language, such as LISP, PERL, C, C++, C#, or in any byte code language such as JAVA. The software programs or executable instructions can be stored on or in one or more articles of manufacture as object code.

While the foregoing written description of the methods and systems enables one of ordinary skill to make and use embodiments thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

## Claims

1. A system, comprising:
a driver configured to provide a first signal to indicate a first amount of power and the first signal having a first level; and
a device in communication with the driver, the device comprising:
a first circuit configured to:
provide, in response to receipt of the first signal, a second signal having a first level based at least on the first level of the first signal;
a second circuit configured to:
detect, in response to receipt of the first signal, the first level of the first signal; and
provide, in response to detection of the first level of the first signal, a third signal to control a third circuit of the device, wherein the third signal controls the third circuit by defining a difference between a first terminal and a second terminal of the third circuit of the device;
the third circuit configured to:
provide, in response to receipt of the first signal and the third signal, a fourth signal, the fourth signal having a first level in response to the difference being smaller than a predetermined value, and the fourth signal having a second level in response to the difference being larger than the predetermined value; and
a fourth circuit configured to:
provide, in response to receipt of the second signal and the fourth signal, a fifth signal, the fifth signal having a first level based at least on the first level of the second signal, and the fifth signal having a second level based at least on the first level of the second signal and the second level of the fourth signal.

2. The system of claim 1, wherein:
the fifth signal has the first level in response to the fourth signal having the first level; and
the fifth signal has the second level in response to the fourth signal having the second level.

3. The system of claim 1 or 2, wherein the second level of the fifth signal is larger than the second level of the fourth signal, and wherein the second level of the fourth signal is larger than first level of the second signal.

4. The system of any preceding claim, wherein the first level of the second signal is larger than the first level of the fourth signal, and wherein the first level of the second signal is smaller than the second level of the fourth signal.

5. The system of any preceding claim, wherein the first level of the first signal has a first value in response to the first amount of power pertaining to a first mode of the device, and wherein the first level of the first signal has a second value in response to the first amount of power pertaining to a second mode of the device.

6. The system of claim 5, wherein the first mode of the device pertains to communication corresponding to a first protocol, and wherein the second mode of the device pertains to communication corresponding to a second protocol.

7. The system of any preceding claim, further comprising:
a fifth circuit configured to:
receive, prior to the fourth circuit, the fourth signal;
adjust, in response to the fourth signal having the first level, a first amount of resistance experienced by the first circuit from a first value to a second value; and
provide, in response to adjustment in the first amount of resistance, the fourth signal to the fourth circuit;
wherein the second value of the first amount of resistance dictates the first level of the fifth signal;
wherein the second value of the first amount of resistance is larger than the first value of the first amount of resistance.

8. The system of claim 7, wherein the fifth circuit is configured to adjust the first amount of resistance by:
modifying a second amount of resistance associated with the fourth signal from a first value to a second value; and
wherein the second value of the second amount of resistance is less than the second value of the first amount of resistance.

9. The system of claim 7 or 8, wherein the fifth circuit is positioned between the third circuit and the fourth circuit, and wherein the fifth circuit is located in series to the third circuit and the fourth circuit.

10. The system of any preceding claim, further comprising:
a fifth circuit configured to:
receive, prior to the fourth circuit, the fourth signal;
adjust, in response to the fourth signal having the second level, a first amount of resistance experienced by the first circuit from a first value to a second value; and
provide, in response to adjustment in the first amount of resistance, the fourth signal to the fourth circuit;
wherein the second value of the first amount of resistance is smaller than the first value of the first amount of resistance;
wherein an amount of the fifth signal that is based on the first level of the second signal is reduced in response to the first amount of resistance having the second value.

11. The system of any preceding claim, further comprising:
the first circuit configured to receive a first instance of the first signal; and
the third circuit configured to receive a second instance of the first signal;
wherein the second instance of the first signal is offset from the first instance of the first signal by a predetermined amount.

12. A device in communication with a driver, the device configured to receive a first signal from the driver, and the device comprising:
a first circuit configured to:
provide, in response to receipt of the first signal, a second signal having a first level based at least on a first level of the first signal;
a second circuit configured to:
detect, in response to receipt of the first signal, the first level of the first signal; and
provide, in response to detection of the first level of the first signal, a third signal to control a third circuit of the device, wherein the third signal controls the third circuit by defining a difference between a first terminal and a second terminal of the third circuit of the device;
the third circuit configured to:
provide, in response to receipt of the first signal and the third signal, a fourth signal, the fourth signal having a first level in response to the difference being smaller than a predetermined value, and the fourth signal having a second level in response to the difference being larger than the predetermined value; and
a fourth circuit configured to:
provide, in response to receipt of the second signal and the fourth signal, a fifth signal, the fifth signal having a first level based at least on the first level of the second signal, and the fifth signal having a second level based at least on the first level of the second signal and the second level of the fourth signal.

13. The device of claim 12, wherein:
the fifth signal has the first level in response to the fourth signal having the first level; and
the fifth signal has the second level in response to the fourth signal having the second level.

14. The device of claim 12 or 13, wherein the second level of the fifth signal is larger than the second level of the fourth signal, and wherein the second level of the fourth signal is larger than first level of the second signal.

15. A method comprising:
receiving, by a device, from a driver, a first signal to indicate a first amount of power and the first signal having a first level;
providing, by a first circuit of the device, in response to receipt of the first signal, a second signal having a first level based at least on the first level of the first signal;
detecting, by a second circuit of the device, in response to receipt of the first signal, the first level of the first signal;
providing, by the second circuit of the device, in response to detection of the first level of the first signal, a third signal to control a third circuit of the device, wherein the third signal controls the third circuit by defining a difference between a first terminal and a second terminal of the third circuit of the device;
providing, by the third circuit of the device, in response to receipt of the first signal and the third signal, a fourth signal, the fourth signal having a first level in response to the difference being smaller than a predetermined value, and the fourth signal having a second level in response to the difference being larger than the predetermined value; and
providing, by a fourth circuit of the device, in response to receipt of the second signal and the fourth signal, a fifth signal, the fifth signal having a first level based at least on the first level of the second signal, and the fifth signal having a second level based at least on the first level of the second signal and the second level of the fourth signal.
